# EUROPEAN PATENT APPLICATION

(11) **EP 2 466 650 A2**
(43) Date of publication of application: **20.06.2012**
(21) Application number: 11401619.9
(22) Date of filing: 21.10.2011
(51) Int. Cl.: H01L 31/18

(54) **Method for fabricating silicon wafer solar cell**

(30) Priority: 22.10.2010 TW 99136112
(71) Applicant: Wakom Semiconductor Corporation, Hsinchu County 303 (TW)
(72) Inventor: Chien, Ray, 303 Hsinchu County (TW); Hsieh, Jih-Shun, 303 Hsinchu County (TW); Lin, Yu-Mei, 303 Hsinchu County (TW)
(74) Representative: Lang, Christian

(57) **Abstract**

The invention provides a method for fabricating a silicon wafer solar cell, comprising the following steps: texturing a silicon wafer, forming a p-n junction, performing a wet chemical surface treatment, performing a passivation layer formation process, and performing electrodes formation process, wherein the wet chemical surface treatment comprises the following specific process flow: performing a backside phosphosilicate glass (PSG) removal process, performing an edge isolation and backside polish process, performing a double-side phosphosilicate glass and oxide removal process, and performing a front-side shallow junction formation process.

## Description

### Background of the invention

### (a) Field of the Invention

The invention relates to a method for fabricating a silicon wafer solar cell, particularly to a wet chemical surface treatment process flow.

### (b) Description of the Related Art

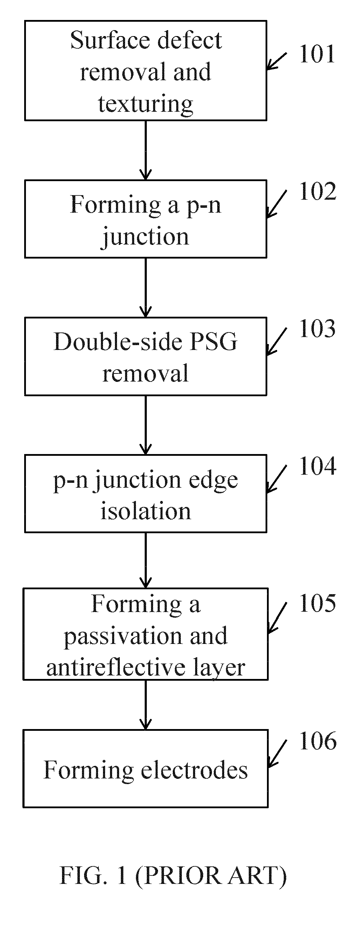

In general, the conventional method for fabricating a silicon wafer solar cell, such as the process flow shown in FIG. 1, uses a p-type wafer as a substrate and at first removes the surface defect of the wafer and carries out surface texturization to the wafer (step 101). Then, step 102 is to form a p-n junction, that is, to form a surface-uniform n-type emitter layer by high temperature phosphorus diffusion. Step 103 is to perform a wet chemical process to remove phosphosilicate glass (PSG) on the surface. It is because a PSG insulation layer is formed with a thickness of 20∼100 nm (nano-meter) on the surface of wafer when POCL₃ doping and diffusion process is performed in a high temperature furnace, the PSG layer needs to be removed afterwards. Step 104 is to perform p-n junction edge isolation to remove parasitic n-type layers on the periphery of the wafer (that is, edges) and the backside of the wafer formed during phosphorus diffusion. The purpose of step 104 is to prevent electrical short-circuit through leakage current at the edges between the front and back sides of the solar cell after the solar cell is fabricated. Thus, the photo-electron conversion efficiency will not decrease due to leakage current at the edges. Step 105 is to form a passivation layer and/or anti-reflective layer, for example, by a chemical vapor deposition method. Finally, step 106 is to form upper and lower electrodes, for example, by using a stencil printer to print electrode pattern(s) and then applying co-firing to fabricate a solar cell. As for other methods, one may refer to, for example, Stautory Invention Registrtion (SIR) H2207H, US patent No. 4,070,689, etc.

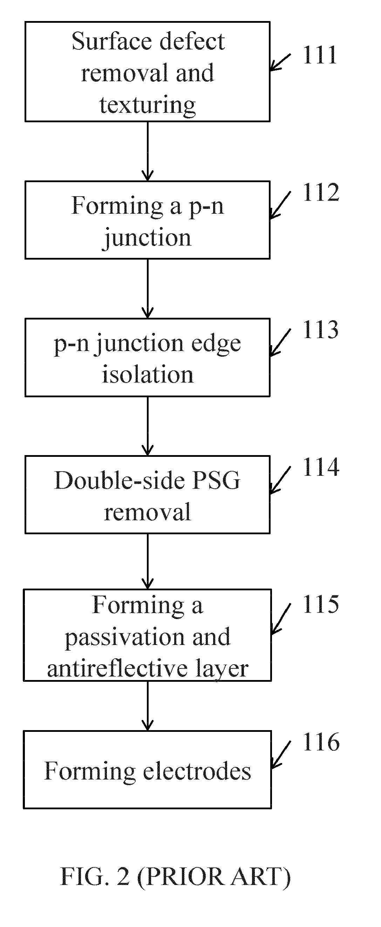

Besides, German patent DE10313127B4 by RENA Sondermaschinen GmbH discloses a process for preventing short circuiting in silicon wafers used in the solar cell industries comprises etching the lower sides of the wafers to remove the parasitic layer doped with phosphorus. The process at first performs wet etching edge isolation and at the same time removes backside PSG and then removes double-side (or the front side) PSG. According to the above description, for example the method for fabricating a silicon wafer solar cell has the process flow shown in FIG. 2. The process flow is in order of 111→112→113→114→115→116. The difference between FIG. 1 and FIG. 2 is that edge isolation (step 113) is performed before double-side PSG removal (step 114) where steps 111, 112, 115, and 116 are the same as steps 101, 102, 105, and 106, respectively. Since in the method (FIG. 2) PSG is still on the wafer when the edge isolation process is performed, the edge isolation process needs more powerful etching solution (acidic solution comprising HF) such as a HNO₃+HF mixed acidic solution to simultaneously etch the silicon layers and (PSG) oxide layers. Furthermore, US patent No. 7,943,526 discloses a process for the wet-chemical treatment of one side of silicon wafers. The process controls the top surface of the silicon wafer to be always above the liquid level, and no protection is needed for the top surface of the silicon wafer which is intended not to be processed. However, if the etchant sprays or creeps to contact with the top surface of the silicon wafer, the top surface of the silicon wafer will be damaged by the etchant

However, in the above edge isolation process (step 113) shown in FIG. 2, since the silicon layer and (PSG) oxide layer on the backside (or backside and edges) of the wafer are required to be etched simultaneously, if the etching solution contacts with the front side or the periphery of the front side (by being sprayed, creeping or overflowing onto the front side), the etching solution will etch the silicon layer on the front side and will damage the texture structure on the front side locally, and hence it will slightly decrease the photo-electron conversion efficiency. On the other hand, in the above edge isolation process (step 104) shown in FIG. 1, since the front-side PSG has been removed (step 103), if the silicon etching solution contacts with the front side or the periphery of the front side, the silicon layer on the front side will be etched locally and it will damage the texture structure on the front side, and hence it will slightly decrease the photo-electron conversion efficiency. The above two prior methods for edge isolation, shown in FIGS. 1 and 2 have the above mentioned problems in real production environments.

In the structure development and fabrication method of a silicon wafer solar cell, the important tasks are to increase the photo-electron conversion efficiency and simultaneously to reduce production costs. In respect to the increase of the photo-electron conversion efficiency, for example, the process methods considering factors such as materials, light trapping technique, band gap engineering, p-n junction depth, surface & bulk passivation and anti-reflective layer, electrode engineering, parasitic shunt circuit, etc. have been developed. In order to reduce production costs, novel processes and equipments are still under development, and they need production verification and continuous improvements. Therefore, a novel method for fabricating a silicon wafer solar cell which is to increase the photo-electron conversion efficiency and simultaneously to reduce production costs is still urgently needed in the industry.

### BRIEF SUMMARY OF THE INVENTION

In light of the above-mentioned problem in the prior arts, one object of the invention is to provide a method for fabricating a silicon wafer solar cell for the sake of increasing the photo-electron conversion efficiency. A shallow junction structure is formed on the front side of the wafer by a wet process applied to the front side (the surface facing sunlight). The wet process is to make the p-n junction to be a shallow junction and thereby increases the probability of photo-current generation from incident light so as to increase the photo-electron conversion efficiency.

Besides, another object of the invention is by using a specific process flow in the wet chemical surface treatment to complete the processes of PSG removal, backside polishing, p-n junction edge isolation, and forming a front-side shallow junction structure for the sake of increasing the photo-electron conversion efficiency and simultaneously decreasing the production costs for fabricating a silicon wafer solar cell. The specific process flow of the wet chemical surface treatment is that at first performs a backside (that is, single side) phosphosilicate glass (PSG) removal process where the PSG layer on the front side of the wafer is kept and acts as the front-side etch protective layer (etch mask layer) when performing the subsequent edge isolation (and backside polishing) process, in order to prevent the front-side textured surface from being damaged by the silicon etchant accidentally creeping or being sprayed onto the front side surface. Thereafter, the two sides of the wafer contact with an etchant to perform a double-side (that is, front side and backside) PSG and oxide removal. Finally, the two sides of the wafer contact with an etchant to slightly etch silicon on the surface to form a front-side shallow junction structure.

In order to achieve the above objectives, one embodiment of the invention provides a method for fabricating a silicon wafer solar cell. The method comprises the following processes: texturing a silicon wafer, forming a p-n junction, performing a wet chemical surface treatment, performing a passivation layer and/or anti-reflective layer formation process (where "and/or" meaning that forming the anti-reflective layer is another name and one purpose for the passivation layer), and performing electrode formation process. The wet chemical surface treatment comprises the following specific process flow:

At first, a backside phosphosilicate glass (PSG) removal process is performed by using a first etching solution to have the first etching solution contact with the backside of the silicon wafer or contact with the backside and the edges of the silicon wafer in order to remove phosphosilicate glass (PSG) on the backside of the silicon wafer or the backside and the edges of the silicon wafer, where the ratio of silicon dioxide etching rate to silicon etching rate of the first etching solution is more than or equal to 10/1. A front side of the silicon wafer is defined as the light incident surface after the silicon wafer is made into a solar cell, the backside of the silicon wafer is the surface opposite to the front side, and the edges of the silicon wafer are the surfaces connected in between the front side and the backside.

An edge isolation process is performed by using a second etching solution. The second etching solution has a property of having a silicon etching rate much higher than its PSG etching rate and thus a purposely remained PSG layer on the front side of the wafer is used as a silicon etch mask in order to prevent a silicon layer on the front side from being accidentally etched and damaged by the second etching solution. The second etching solution contacts with the backside, the edges and the front side of the silicon wafer (that is, the wafer is completely submerged in the second etching solution), or contact with the backside, the edges and the periphery of the front side of the silicon wafer because of liquid surface tension (the second etching solution contacts with the periphery of the front side only because of liquid surface tension and it will not creep or overflow to the majority area on the front side), and thereby the backside (and the edges) of the silicon wafer is etched. The edge isolation process uses the second etching solution to etch silicon by a thickness of about 0.5µm∼15µm (micro-meter), which leads to a smoother backside surface and achieves a slight backside polish effect because second etchant will increase the reflectivity of the backside of the silicon wafer. Since the silicon layer on the front side is shielded by the PSG layer on the top and does not contact with the second etching solution, the texture structure of the silicon layer on the front side of the wafer will not be accidentally etched and damaged (by sprayed etchant or creeping etchant).

A double-side phosphosilicate glass and oxide removal process is performed by using a third etching solution to contact with the front side and backside of the silicon wafer (that is, the wafer is completely submerged in the third etching solution) to remove phosphosilicate glass and other oxides on the surfaces of the silicon wafer.

In the above method for fabricating a silicon wafer solar cell, the wet chemical surface treatment further comprises: performing a front-side shallow junction formation process after the double-side phosphosilicate glass and oxide removal process by using a fourth etching solution to contact with the front side and backside of the silicon wafer (that is, the wafer is completely submerged in the fourth etching solution) to etch silicon on the surfaces of the silicon wafer, in order to reduce the distance (or the depth) between a p-n junction of the front side and the surface of the front side of the silicon wafer so as to form a front-side shallow junction. The etched thickness of the silicon layer on the front side is about 20 nm∼200 nm (nano-meter). Thus, the p-n junction becomes closer to the surface of the wafer, that is, the distance (or the depth) between the p-n junction of the wafer and the surface of the front side of the wafer is reduced so as to form a front-side shallow junction on the silicon wafer solar cell.

According to another embodiment of the invention, a wet chemical surface treatment process flow is provided and is suitable for fabricating a silicon wafer solar cell. The wet chemical surface treatment process flow comprises the following processes: performing a backside phosphosilicate glass (PSG) removal process by using a first etching solution and to have the first etching solution contact with the backside of the silicon wafer or contact with the backside and the edges of the silicon wafer in order to remove phosphosilicate glass (PSG) on the backside of the silicon wafer or the backside and the edges of the silicon wafer wherein the ratio of silicon dioxide etching rate to silicon etching rate of the first etching solution is more than or equal to 10/1; a front side of the silicon wafer is defined as the light incident surface after the silicon wafer is made into a solar cell; the backside of the silicon wafer is the surface opposite to the front side, and the edges of the silicon wafer are the surfaces connected in between the front side and the backside; performing an edge isolation process by using a second etching solution to have the second etching solution contact with the backside of the silicon wafer or contact with the backside and the edges of the silicon wafer and contact with the periphery of the front side of the silicon wafer because of liquid surface tension (the second etching solution contacts with the periphery of the front side only because of liquid surface tension and it will not creep or overflow to the majority area on the front side), in order etch the backside and the edges of the silicon wafer so as to have the front side and the backside be electrically decoupled at the edges, wherein the ratio of silicon etching rate to phosphosilicate glass oxide etching rate of the second etching solution is more than or equal to 5/1; and performing a double-side phosphosilicate glass and oxide removal process by using a third etching solution to contact with the front side and backside of the silicon wafer to remove phosphosilicate glass and oxides on the surfaces of the silicon wafer.

The above-mentioned wet chemical surface treatment further comprises: performing a front-side shallow junction formation process after the double-side phosphosilicate glass and oxide removal process by using a fourth etching solution to contact with the front side and backside of the silicon wafer (that is, the wafer is completely submerged in the fourth etching solution) in order to etch silicon on the surfaces of the silicon wafer so as to reduce the distance between a p-n junction of the front side and the surface of the front side of the silicon wafer and hence forming a front-side shallow junction. The etched thickness of the silicon layer on the front side is typically in the range of 20 nm∼200 nm (nano-meter). Thus, the p-n junction becomes closer to the surface of the wafer and hence it forms a front-side shallow junction on the silicon wafer solar cell.

In the above embodiments, the first etching solution can be an acidic solution comprising fluoride ions such as, but not limited to, HF solution. The ratio of the silicon dioxide etching rate to the silicon etching rate of the first etching solution is more than or equal to 10/1 and is preferably more than or equal to 100/1. The second etching solution is an alkaline solution such as, but not limited to, KOH solution and NaOH solution. The third etching solution is an acidic solution comprising fluoride ions such as, but not limited to, HF solution. The fourth etching solution is an alkaline solution such as, but not limited to, tetramethyl ammonium hydroxide (TMAH), ethylene-diamine pyrocatechol water (EDP), hydrazine, sodium hydroxide, potassium hydroxide, sodium carbonate, and potassium carbonate.

In one embodiment, the first etching solution comprises one compound selected from the group consisting of the following: hydrofluoric acid (HF), ammonium fluoride (NH₄F), ammonium hydrogen fluoride (NH₄HF₂), and trifluoroacetic acid (CF₃COOH). In one embodiment, the second etching solution comprises one compound selected from the group consisting of the following: sodium hydroxide (NaOH), potassium hydroxide (KOH), sodium carbonate (Na₂CO₃), and potassium carbonate (K₂CO₃). In one embodiment, the third etching solution comprises one compound selected from the group consisting of the following: hydrofluoric acid (HF), ammonium fluoride (NH₄F), ammonium hydrogen fluoride (NH₄HF₂), and trifluoroacetic acid (CF₃COOH). In one embodiment, the fourth etching solution comprises one compound selected from the group consisting of the following: tetramethyl ammonium hydroxide (TMAH), ethylene-diamine pyrocatechol water (EDP), hydrazine, sodium hydroxide, potassium hydroxide, sodium carbonate, and potassium carbonate.

Furthermore, according to another embodiment of the invention, a method for fabricating a silicon wafer solar cell, comprising: texturing a silicon wafer, forming a p-n junction, performing a wet chemical surface treatment, performing a passivation layer (or anti-reflective layer) formation process, and performing electrodes formation processes. By transporting a silicon wafer horizontally by a roller conveyor means, the wet chemical surface treatment comprises the following specific sequential process flow: performing a phosphosilicate glass (PSG) removal process by using a first etching solution to remove all of phosphosilicate glass (PSG) on the surfaces of the silicon wafer or phosphosilicate glass (PSG) on the backside of the silicon wafer wherein the silicon dioxide etching rate of the first etching solution is larger than the silicon etching rate of the first etching solution; a front side of the silicon wafer is defined as the light incident surface after the silicon wafer is made into a solar cell; the backside of the silicon wafer is the surface opposite to the front side, and the edges of the silicon wafer are the surfaces connected in between the front side and the backside; performing an edge isolation process by using a second etching solution to have the front side and the backside be electrically decoupled at the edges; performing a front-side shallow junction formation process after the double-side phosphosilicate glass and oxide removal process by using a third etching solution to contact with the front side and backside of the silicon wafer in order to etch silicon on the surfaces of the silicon wafer so as to reduce the distance between the p-n junction of the front side and the surface of the front side of the silicon wafer and hence forming a front-side shallow junction; and furthermore performing water rinse processes between the processes of the wet chemical surface treatment process flow by using deionized water to rinse the silicon wafer.

In the above embodiment, in the front-side shallow junction formation process, the etched thickness of silicon on the front side of the silicon wafer is a thickness in the range of 20 nm∼200 nm and preferably 50 nm∼200 nm.

Therefore, according to the method for fabricating a silicon wafer solar cell of the present invention, the wafer is transported horizontally (for example, by roller conveyor means in a wet bench equipment) to complete the specific wet chemical surface treatment process flow of PSG removal, edge isolation and backside polish, and double-side PSG and oxide removal. The method can increase production capacity and production yield as well. Besides, a front-side shallow junction structure can be formed by the method of the invention to increase the photo-electron conversion efficiency.

Other objects and advantages of the invention can be better understood from the technical characteristics disclosed by the invention. In order to clarify the above mentioned and other objects and advantages of the invention, examples accompanying with figures are provided and described in details in the following.

### Brief description of the drawings

FIG. 1 shows a flow chart illustrating a method for fabricating a silicon wafer solar cell according to a prior art.

FIG. 2 shows a flow chart illustrating a method for fabricating a silicon wafer solar cell according to another prior art.

FIG. 3 shows cross-sectional schematic diagrams illustrating a method for fabricating a silicon wafer solar cell according to a prior art.

FIG. 4 shows cross-sectional schematic diagrams illustrating a method for fabricating a silicon wafer solar cell according to another prior art.

FIG. 5 shows cross-sectional schematic diagrams illustrating a method for fabricating a silicon wafer solar cell according to another prior art.

FIG 6 shows cross-sectional schematic diagrams illustrating a wafer structure during fabricating a silicon wafer solar cell according to one embodiment of the invention.

FIG. 7 shows cross-sectional schematic diagrams illustrating a wafer structure during fabricating a silicon wafer solar cell according to another embodiment of the invention.

FIG. 8 shows a flow chart illustrating a method for fabricating a silicon wafer solar cell according to another embodiment of the invention.

FIG. 9 shows a flow chart illustrating a wet chemical surface treatment sequence according to one embodiment of the invention.

### DETAILED DESCRIPTION OF THE INVENTION

In the following detailed description of the preferred embodiments, reference is made to the accompanying drawings which form a part hereof, and in which are shown by way of illustration specific embodiments in which the invention may be practiced. In this regard, directional terminology, such as "top," "bottom," "front," "back," etc., is used with reference to the orientation of the Figure(s) being described. The components of the invention can be positioned in a number of different orientations. As such, the directional terminology is used for purposes of illustration and is in no way limiting. On the other hand, the drawings are only schematic and the sizes of components may be exaggerated for clarity. It is to be understood that other embodiments may be utilized and structural changes may be made without departing from the scope of the invention.

FIG. 1 shows a flow chart illustrating a method for fabricating a silicon wafer solar cell according to a prior art. Step 104 is the p-n junction edge isolation process. The edge isolation process can use laser edge isolation technique or wet etching edge isolation technique. When step 104 uses the single-side wet etching edge isolation technique, it can increase the photo-electron conversion efficiency by about 0.1%, compared to the laser edge isolation technique. In addition, in the conventional single-side wet etching edge isolation technique, a silicon layer with a thickness about 0.5 µm∼2 µm (micro-meter) is etched on the backside and a parasitic n-layer formed by the doping and diffusion process on the backside and edges of the p-type wafer is removed to order to prevent electrical short-circuit between the front and back sides which will decrease the photo-electron conversion efficiency due to the edge leakage current after the solar cell is formed. Moreover, FIG. 2 shows a flow chart illustrating a method for fabricating a silicon wafer solar cell according to another prior art where step 113 is the p-n junction edge isolation process and the laser edge isolation technique can be used.

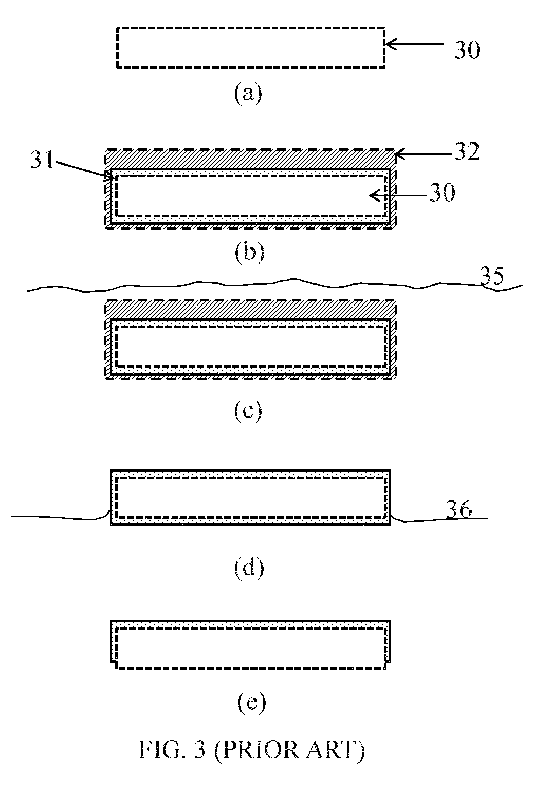

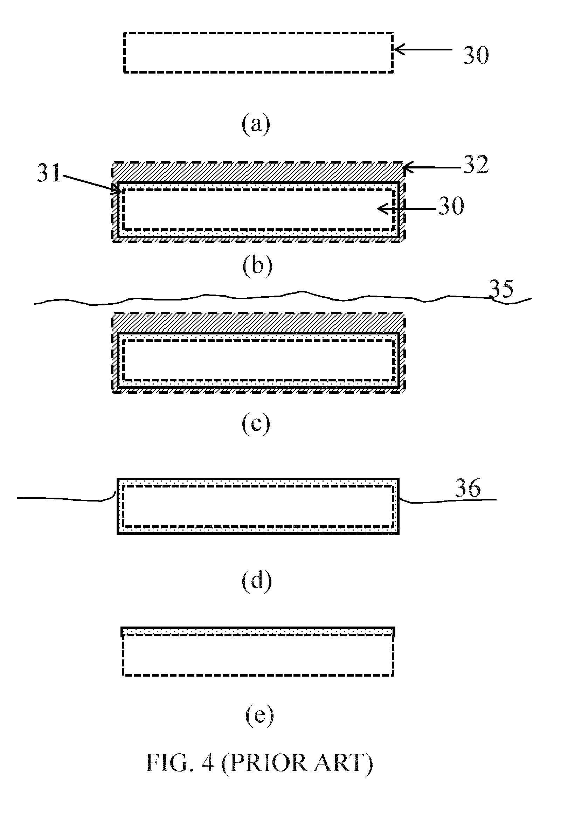

Therefore, the conventional method for fabricating a silicon wafer solar mainly comprises texturing a silicon wafer, forming a p-n junction, performing a wet etching PSG removal and edge isolation process, performing a passivation layer and/or anti-reflective layer formation process, and performing electrode formation process where the wet etching PSG removal and edge isolation process comprises double-side PSG removal and p-n junction edge isolation. Presently, the wet etching (double-side) PSG removal process and the edge isolation process are usually carried out by integrating into one inline wet bench, such as a PSG removal and edge isolation equipment called "InOxSide" by RENA Sondermaschinen GmbH or PSG removal and edge isolation equipment by Gebr. Schmid GmbH & Co. FIG. 3 shows cross-sectional schematic diagrams illustrating a method for fabricating a silicon wafer solar cell according to the prior art where 30 represents a p-type wafer, 31 represents a n-layer on the surface, and 32 represents a PSG layer. In FIG. 3(a) at first the p-type wafer 30 is used; (b) the p-type wafer 30 is surface texturized and then carried out phosphorus diffusion to form the wafer having the n-layer 31 on its surface and the surface of the wafer is covered with the PSG layer 32; (c) the liquid level of the etching solution 35 covers the wafer to have the wafer completely submerged in the etching solution 35 in order to remove the PSG layer 32 on the two sides; (d) after the PSG layer 32 is removed, the etching solution 36 contacts with the back side of the wafer to remove the n-layer 31 on the back side; finally (e) a wafer electrically decoupled at the edges is formed. Besides, FIG. 4 shows cross-sectional schematic diagrams illustrating a method for fabricating a silicon wafer solar cell according to another prior art where the steps (a), (b), and (c) are the same as those of FIG. 3 but step (d) of FIG. 4 is to have the etching solution 36 contact with the back side and edges of the wafer to remove the n-layer 31 on the back side and edges. Finally, in step (e) of FIG. 4, a wafer electrically decoupled at the edges is formed.

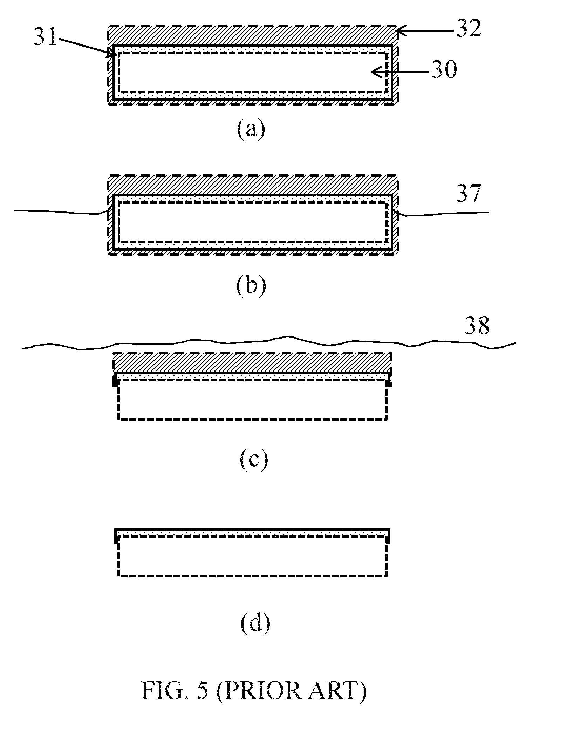

On the other hand, FIG. 5 shows cross-sectional schematic diagrams illustrating a method for fabricating a silicon wafer solar cell according to another prior art. As shown in FIG. 5, the process flow performs the edge isolation process and then removes PSG where (a) the p-type wafer 30 is surface texturized and then carried out phosphorus diffusion to form the wafer having the n-layer 31 on its surface and the surface of the n-layer 31 of the wafer is covered with the PSG layer 32; (b) the etching solution 37 contacts with the back side and edges of the wafer to remove the PSG layer 32 and the n-layer 31 on the back side and edges of the wafer; (c) the liquid level of the etching solution 38 covers the wafer to have the wafer completely submerged in the etching solution 38 in order to remove the PSG layer 32 on the front side. Since PSG is still on the wafer when the edge isolation process is performed, the acidic etching solution 37 used in the edge isolation process (step (b)) is required to etch both the silicon layer and PSG. For example, the HNO₃+HF mixed acidic solution can be used to etch the silicon layers and PSG oxide layers at the same time.

However, in the edge isolation process (step (b)) shown in FIG. 5, since the n-layer 31 and PSG layer 32 on the backside (or backside and edges) of the wafer are required to be etched simultaneously, if the etching solution 37 contacts with the front side or the periphery of the front side (by spraying or creeping onto the front side), the etching solution 37 will etch the silicon layer on the front side and damage the texture structure locally on the front side, which will slightly decrease the photo-electron conversion efficiency. On the other hand, in the edge isolation process (step (d)) shown in FIGS. 3 and 4, since the PSG layer 32 on the front side of the wafer has been removed (after step (c)), if the etching solution 36 contacts with front side or the periphery of the front side, the etching solution 36 will etch the silicon layer on the front side and damage the texture structure locally on the front side, which will slightly decrease the photo-electron conversion efficiency. The above two examples show the above problems in the conventional process flow shown in FIGS. 3, 4 and 5.

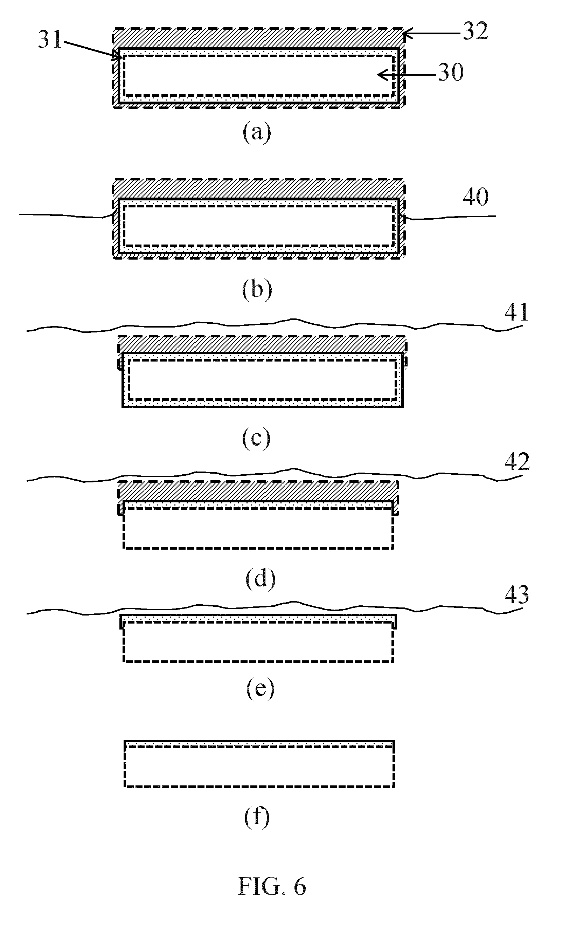

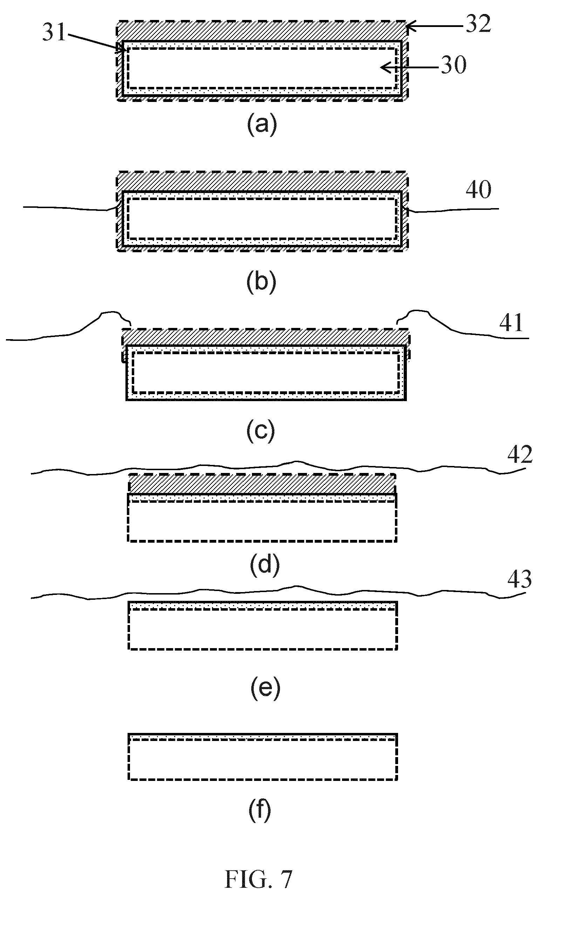

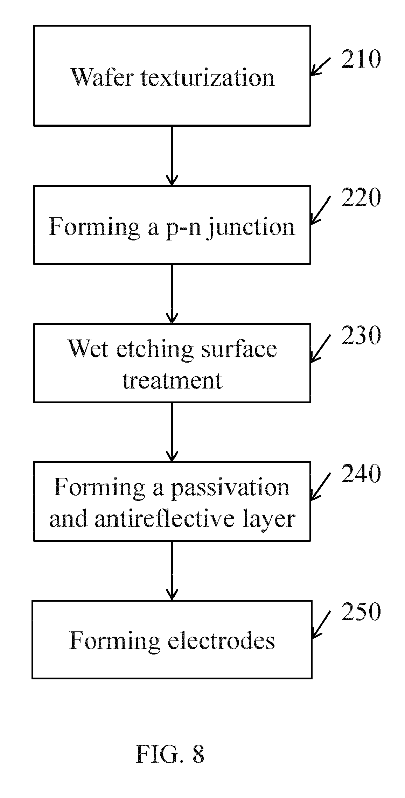

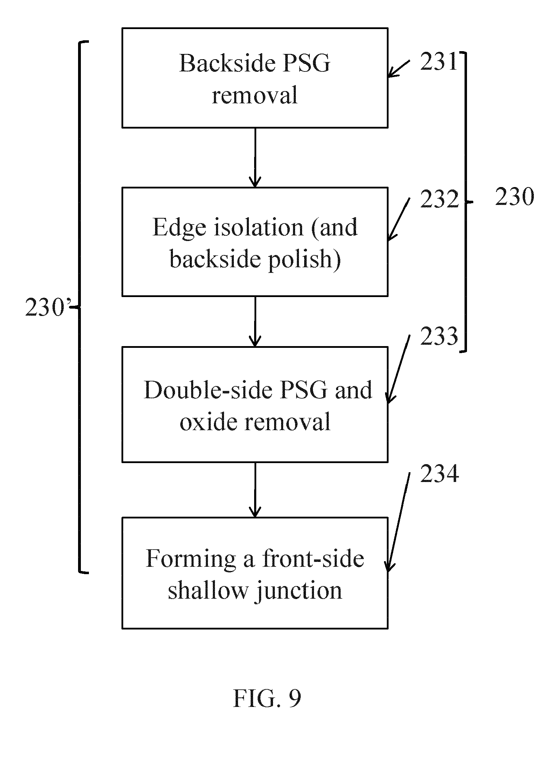

According to a first embodiment of the invention, in order to further improve the wet etching PSG removal and edge isolation process flow, the invention discloses a method for fabricating a silicon wafer solar cell. Please refer to FIGS. 6∼9 where FIG 6 shows cross-sectional schematic diagrams illustrating a wafer structure during fabricating a silicon wafer solar cell according to one embodiment of the invention; FIG. 7 shows cross-sectional schematic diagrams illustrating a wafer structure during fabricating a silicon wafer solar cell according to another embodiment of the invention; FIG. 8 shows a flow chart illustrating a method for fabricating a silicon wafer solar cell according to another embodiment of the invention; and FIG. 9 shows a flow chart illustrating a wet chemical surface treatment according to one embodiment of the invention. As shown in FIG. 8, the process flow comprises: step 210: texturing a silicon wafer, step 220: forming a p-n junction, step 230: performing a wet chemical surface treatment, step 240: performing a passivation layer and anti-reflective layer formation process, and step 250: performing electrodes formation process. As shown in FIG. 9, step 230: performing a wet chemical surface treatment comprises: step 231, step 232, and step 233. Step 231 is to perform a backside phosphosilicate glass (PSG) removal process by using a first etching solution to have the first etching solution contact with the backside of the silicon wafer or contact with the backside and the edges of the silicon wafer to remove phosphosilicate glass (PSG) on the backside of the silicon wafer or the backside and the edges of the silicon wafer, where the ratio of silicon dioxide etching rate to silicon etching rate of the first etching solution is more than or equal to 10/1, preferably more than or equal to 100/1. The front side of the silicon wafer is defined as the surface facing the sun, that is, the light incident surface after the silicon wafer is made into a solar cell, the backside of the silicon wafer is the surface opposite to the front side, and the edges of the silicon wafer are the surfaces connected in between the front side and the backside. Step 232 is to perform an edge isolation process by using a second etching solution. The second etching solution has a property of having a silicon etching rate much higher than its PSG etching rate, and thus a PSG layer purposely remained on the front side of the wafer is used as a silicon etch mask to prevent a silicon layer on the front side from being etched by the second etching solution. The second etching solution contacts with the backside and front side of the silicon wafer (the wafer is completely submerged in the second etching solution) or contact with the backside, the edges, and the periphery of the front side of the silicon wafer because of liquid surface tension, in order to etch the backside and edges of the silicon wafer. The silicon layer with a thickness in the range from 0.5 µm to 15 µm is etched and the electrical decoupling at the edges between the front and back sides of the wafer is then achieved. Step 232 can effectively achieve backside polish to the wafer to increase the reflectivity of the backside of the wafer. The second etching solution contacts with the backside, or the backside and edges to perform surface etching. Step 233 is to perform a double-side phosphosilicate glass and oxide removal process by using a third etching solution to contact with the front side and backside of the silicon wafer to remove phosphosilicate glass and oxides on the surfaces of the silicon wafer. The step 230: performing a wet chemical surface treatment can further comprise step 234 to perform a front-side shallow junction formation process by using a fourth etching solution to have the fourth etching solution contact with the front side and backside of the silicon wafer to etch silicon with a thickness in the range from 20 nm to 200 nm on the surfaces of the silicon wafer to form a front-side shallow junction.

Specifically, referring to FIG. 6, (a) the p-type wafer 30 is surface texturized and then carried out phosphorus diffusion to form the wafer having the n-layer 31 on its surface and the surface of the wafer is covered with the PSG layer 32; (b) the etching solution 40 contacts with the backside and edges of the wafer to remove the PSG layer 32 on the backside and edges and the PSG layer 32 on the front side is purposely remained; (c) the etching solution 41 covers the wafer to have the wafer completely submerged in the etching solution 41 to remove the n-layer 31 on the back and edges and the n-layer 31 on the front side is not etched because it is protected by the PSG layer 32 and therefore the etching solution 41 cannot easily etch the n-layer 31 on the front side; (d) the etching solution 42 covers the wafer to completely remove the PSG layer 32; (e) the etching solution 43 covers the wafer to etch silicon with a thickness in the range from 20 nm to 200 nm so as to form a front-side shallow junction; and (f) a wafer electrically decoupled at the edges and having a front-side shallow junction is formed.

In the above, the etching solution 40 is the first etching solution, which can comprise hydrofluoric acid (HF), ammonium fluoride (NH₄F), ammonium hydrogen fluoride (NH₄HF₂), trifluoroacetic acid (CF₃COOH), etc. and preferably hydrofluoric acid (HF) solution. The etching solution 41 is the second etching solution, which can comprise sodium hydroxide (NaOH), potassium hydroxide (KOH), sodium carbonate (Na₂CO₃), potassium carbonate (K₂CO₃), etc. and preferably sodium hydroxide (NaOH) solution and potassium hydroxide (KOH) solution. The etching solution 42 is the third etching solution, which can comprise hydrofluoric acid (HF), ammonium fluoride (NH₄F), ammonium hydrogen fluoride (NH₄HF₂), trifluoroacetic acid (CF₃COOH), etc. and preferably hydrofluoric acid (HF) solution. The etching solution 43 is the fourth etching solution, which can comprise tetramethyl ammonium hydroxide (TMAH), ethylene-diamine pyrocatechol water (EDP), hydrazine, sodium hydroxide, potassium hydroxide, sodium carbonate, potassium carbonate, etc. and preferably tetramethyl ammonium hydroxide (TMAH) solution.

In another embodiment, in FIG. 6, step (e): forming a front-side shallow junction can be omitted while it is not needed.

Besides, referring to FIG. 7, in another embodiment, except that step (c) of FIG. 7 is partially different from step (c) of FIG. 6, steps (a), (b), (d), and (e) of FIG. 7 are the same as those of FIG. 6. In step (c) of FIG. 7, the etching solution 41 contacts with the backside, edges, and front-side periphery only so as to remove the n-layer 31 on the backside and edges. Since the front side is protected by the PSG layer 32, the etching solution 41 cannot easily etch silicon on front side (and front side periphery).

In another embodiment, in FIG. 7, step (e): forming a front-side shallow junction can be omitted while it is not needed.

In the above, between steps of the wet chemical surface treatment, (*i.e.* between the backside phosphosilicate glass (PSG) removal process and the edge isolation process, between the edge isolation process and the double-side phosphosilicate glass and oxide removal process, and between the double-side phosphosilicate glass and oxide removal process and the front-side shallow junction formation process) a water rinse process is furthermore performed to rinse the silicon wafer by using deionized water for the sake of preventing the chemical used in the previous process from contaminating the wafer surface in the subsequent etching process.

Step 210: texturing a silicon wafer and step 220: forming a p-n junction can be implemented by the conventional methods. During step 210, when texturing a silicon wafer is performed, the defects on the surface of the wafer are also removed. Step 220: forming a p-n junction can be implemented by a doping and diffusion processes.

In FIG. 7, the above first etching solution comprises one compound selected from the group consisting of the following: hydrofluoric acid (HF), ammonium fluoride (NH₄F), ammonium hydrogen fluoride (NH₄HF₂), and trifluoroacetic acid (CF₃COOH). The above second etching solution comprises one compound selected from the group consisting of the following: sodium hydroxide (NaOH), potassium hydroxide (KOH), sodium carbonate (Na₂CO₃), and potassium carbonate (K₂CO₃). The above third etching solution comprises one compound selected from the group consisting of the following: hydrofluoric acid (HF), ammonium fluoride (NH₄F), ammonium hydrogen fluoride (NH₄HF₂), and trifluoroacetic acid (CF₃COOH). The above fourth etching solution comprises one compound selected from the group consisting of the following: tetramethyl ammonium hydroxide (TMAH), ethylene-diamine pyrocatechol water (EDP), hydrazine, sodium hydroxide, potassium hydroxide, sodium carbonate, and potassium carbonate.

The following describes the wet chemical surface treatment process flow according to the invention. Please refer to FIG. 9. Step 230 (wet chemical surface treatment process) comprises steps 231∼233 while step 230' comprises steps 231∼234.

Step 231: backside phosphosilicate glass (PSG) removal process is a single-side wet etching process. In step 231, a backside phosphosilicate glass (PSG) removal process is performed by using a first etching solution to contact with the backside and the edges of the silicon wafer to remove phosphosilicate glass (PSG) on the backside and the edges of the silicon wafer. Step 231 only etches phosphosilicate glass (PSG) on the backside and the edges of the silicon wafer and keeps phosphosilicate glass (PSG) on the front side purposely as a front-side silicon etch mask. The chemical etching solution used in step 232 reacts with silicon to perform silicon etching. If the chemical etching solution is sprayed or creeps onto the front side of the wafer, the surface texture structure uncovered by the PSG layer will be locally damaged, and it will slightly increase the reflectivity of the wafer. It is very important in step 231 to remove PSG on the backside but keeps PSG purposely on the front side. If the surface texture structure on the front side of the wafer is damaged locally in the subsequent processes, the reflectivity of a locally damaged area will increase to 16% or to even higher than 30%. Therefore, it is an important reason to temporarily keep the PSG layer on the front side as the subsequent silicon etch mask to protect the surface texture structure in the subsequent silicon etching processes.

In step 231, an acidic etchant is used to remove the backside PSG layer with a thickness of, for example, about 50 nm on the surface of the wafer generated by the reaction of POCl₃ and silicon in the previous doping and diffusion processes (step 220). Since the etching reaction only removes PSG but not silicon, hydrofluoric acid (HF) solution is selected as the etchant because it has a high selectivity ratio of PSG etching rate to silicon etching rate. Thus, when PSG on the backside is completely removed, the etching reaction almost stops because hydrofluoric acid (HF) solution cannot etch silicon easily.

The etching reaction of HF on PSG is shown as SiO2+6HF → H₂SiF₆+2H₂O. The product H₂SiF₆ dissolves in water as the effect of etching PSG. Step 231 requires removing about 50 nm of PSG and 10wt% HF can be selected as the etching solution and the etching rate is measured to be about 40 nm/min. By adjusting the concentration and the temperature of HF, the processing time (or duration) can be maintained within a predetermined range, such as to have the SiO₂ (or PSG) etching rate in the range of 50∼100 nm/min.

Thereafter, deionized water can be used to rinse the wafer and the wafer is ready for step 232.

Step 232: edge isolation and backside polish process is a single-side wet etching process. In step 232, an edge isolation process is performed by using a second etching solution to have the second etching solution contact with the backside and front side of the silicon wafer (that is, completely submerged in the second etching solution) or contact with the backside, the edges and the periphery of the front side of the silicon wafer (the second etching solution contacts with the periphery of the front side only because of liquid surface tension and it will not creep or overflow to the majority area on the front side) to etch the backside and edges of the silicon wafer, in order to have the front side and the backside be electrically decoupled at the edges. The second etching solution can use, for example, an alkaline solution such as KOH.

The purpose of step 232 is to remove parasitic n-type layers formed during the phosphorus diffusion on the backside and edges of the silicon wafer to prevent electrical short-circuit through leakage current at the edges between the front and back sides of the solar cell after the solar cell is fabricated. Thus, the photo-electron conversion efficiency will not decrease due to leakage current. At the same time, a layer of silicon with a thickness in the range from about 0.5 µm to 15 µm on the backside is etched and thus a smoother surface structure can be formed on the backside, which will slightly increase backside internal reflectivity and slightly increase the probability of the internally-reflected infrared photons to be re-absorbed by the p-n junction. In practice, such a backside polish technique can effectively increase the photo-electron conversion efficiency by about 0.05%∼0.1% for a thin solar cell.

In step 232, the second etching solution should be suitable for both e mono-crystalline silicon wafers and multi-crystalline silicon wafers. Generally, in order to achieve the edge isolation effect of the p-n junction on the backside and the edges of the silicon wafer, the etched depth of silicon in the range from 0.5 µm to 1 µm is enough. In order to achieve the backside polish effect, the etched depth of silicon requires is higher than 1 µm or even higher than 15 µm.

The second etching solution can use, for example, an alkaline solution such as KOH to achieve the edge isolation and backside polish effect. The condition of KOH, for example, can be 70 ∼85 and 20wt% concentration. Thereafter, deionized water can be used to rinse the wafer and the wafer is ready for step 233.

Step 233: double-side phosphosilicate glass and oxide removal process is a double-side wet etching process. In step 233, a third etching solution is used to remove phosphosilicate glass on the front side and a trace amount of oxides remained on the backside of the silicon wafer. Since a part of phosphosilicate glass (PSG) is purposely remained on the front side as the etch mask for step 232 after the backside PSG removal step (step 231), it is removed in step 233.

In step 233, the third etching solution can use the same acidic etching solution as that in step 231, such as HF. Generally, in order to completely remove PSG layers, etching PSG or SiO₂ can be carried out by over etching the PSG.

The etching reaction of HF and PSG is shown as SiO₂+6HF → H₂SiF₆+2H₂O. The product H₂SiF₆ dissolves in water to achieve the effect of etching PSG. Step 231 requires removing about 50 nm thickness of PSG and 10wt% HF can be selected as the etching solution and the etching rate is measured to be about 40 nm/min in one example. By adjusting the concentration and the temperature of HF, the processing time (or duration) can be maintained within a predetermined range, such as 1 min., in order to have the SiO₂ (or PSG) etching rate be 50∼100 nm/min.

Then, deionized water can be used to rinse the wafer and the wafer is ready for step 234. Or, instead of performing the step 234, steps 240 and 250 are performed directly when step 234 is omitted.

In the case of performing step 234, step 234: performing a front-side shallow junction formation process is a double-side wet etching process. To form a front-side shallow junction structure, a fourth etching solution is used to contact with the front side and backside of the silicon wafer in order to etch silicon by a thickness in the range from 20 nm to 200 nm on the surfaces of the silicon wafer. Step 234 removes silicon with a thickness of 20 nm∼200 nm both on the front side and the backside and preferably 20 nm∼100 nm to form a front-side shallow junction.

Currently, in a p-type solar cell, the n-type emitter surface is the front-side light incident surface. Since the absorption coefficient α(λ) of short-wavelength light in a silicon lattice is large, the incident light energy density ratio (P/P₀) is quickly attenuated as the photon penetration depth increases. However, since the energy of the short-wavelength light (hν) is higher than the band gap of the p-n junction and the probability of photo-electron conversion is higher than the long-wavelength light, the p-n junction depth of a solar cell should be engineered based on the short-wavelength light source. When the p-n junction depth is too deep, an optically inert layer is present on the surface of the emitter and thus the incident light absorption cannot be efficiently utilized to generate photo-current, thereby the photo-electron conversion efficiency will decrease. Besides, a semiconductor band-gap absorbs light close to its surface and generates electron-hole pairs and electron-hole pairs will flow toward two electrodes. If the p-n junction depth is too deep, the recombination probability increases before holes reach the emitter and hence decrease the photo-current. Therefore, the emitter junction of the solar cell should be a shallow junction. But, the shallow junction may have side effect (negative effect) when it is too shallow. For example, when the emitter metal contact is made by co-firing silver paste on the n-layer, when it penetrates into the p-type wafer, an electrical short-circuit between n-layer and p-type wafer occurs. The temperature of the subsequent high temperature firing process should be adjusted to prevent the emitter metal (negative electrode) from diffusing to contact with the p-type wafer which causes electrical short-circuit. Therefore, the wet etching depth of silicon on the surface of the wafer cannot be too large. Since the etching depth of silicon of the wafer is only about 20 nm∼200 nm, the front side and the backside silicon etching can be carried out at the same time without causing undesired negative effect on the backside of the wafer. That is, step 234 can be a double-side silicon etching process.

In step 234, an alkaline etching solution can be used, such as potassium hydroxide (KOH), tetramethyl ammonium hydroxide (TMAH), ethylene-diamine pyrocatechol water (EDP), etc. The chemical reaction equation of the KOH etching solution is Si+2OH⁻+4H₂O→Si(OH)²⁺+2H₂+4OH⁻. The required etching depth of silicon of the wafer is only about 20 nm∼200 nm to form a shallow emitter. Although TMAH and EDP have the high silicon to silicon dioxide etching rate selectivity (Si/SiO₂=2000:1 and 10000:1, respectively), TMAH and EDP are toxic and thus the fourth etching solution is preferably potassium hydroxide (KOH). The silicon to silicon dioxide etching rate selectivity (Si/SiO₂) is about 200:1. That is, when the KOH solution is used and the etching amount of silicon is a depth of 1 µm, the etching amount of silicon dioxide is a depth of about 0.005 µm and etching amount of PSG is a depth larger than 0.005 µm. The concentration of KOH can be adjusted to have the desired etching rate, such as 0.0025 µm/min (at 20 ) using the KOH solution with KOH: H₂O (in weight) = 1:4. By controlling the concentration and the temperature of KOH, the processing time (or duration) can be maintained within a predetermined range, such as 1 min in order to have the silicon etching rate in the range from 20 nm/min. to 200 nm/min.

Then, deionized water can be used to rinse the wafer and the wafer is ready for steps 240 and 250.

Step 240: performing a passivation layer or anti-reflective layer formation process is to form the passivation layer or the anti-reflective layer. Step 250: performing electrodes formation process is to, for example, print silver paste on the wafer to form an electrode pattern and perform co-firing process to the silver paste.

The above steps 231, 232, 233, and 234 can be implemented by using a roller conveyor means (in a wet bench equipment) to horizontally transport silicon wafers. The conveyor means may comprise a plurality of rollers and a chemical control means. Thus, the production speed can be increased, such as transporting 1200∼3600 wafers/hr, that is, producing 1200∼3600 wafers per hour.

The method for fabricating a silicon wafer solar cell according to the first embodiment of the invention can increase not only the production speed but also the production yield as well as the photo-electron conversion efficiency.

According to a second embodiment of the invention, a wet chemical surface treatment process flow is disclosed and is suitable for fabricating a silicon wafer solar cell. The wet chemical surface treatment process flow comprises the above steps 231, 232, and 233 and can further comprise the above step 234. The implementation of the steps 231, 232, and 233 of the second embodiment can be the same as those described in the first embodiment. Similarly, the wet chemical surface treatment process flow of the second embodiment can use a roller conveyor means (in a wet bench equipment) to horizontally transport silicon wafers. The wet chemical surface treatment process flow according to the second embodiment of the invention can increase not only the production speed but also the production yield as well as the photo-electron conversion efficiency.

Furthermore, according to a third embodiment of the invention, a method for fabricating a silicon wafer solar cell is disclosed. The characteristic of the method according to the third embodiment is that step 234 is performed to form a front-side shallow junction and the other processes are the same as the previous embodiments. Therefore, the front-side shallow junction can further increase the photo-electron conversion efficiency.

Besides, the above single-side etching process can use the prior method disclosed in, for example, EP2113935 or TW M347670. However, other embodiment of the conveyor means can be conceived and employed, and is not limited by the method disclosed in EP2113935 or TW M347670

In conclusion, the method for fabricating a silicon wafer solar cell and the wet chemical surface treatment process flow of the invention can not only increase the production speed but also the production yield as well as the photo-electron conversion efficiency.

Although the present invention has been fully described by the above embodiments, the embodiments should not constitute the limitation of the scope of the invention. Various modifications or changes can be made by those who are skilled in the art without deviating from the spirit of the invention. Any embodiment or claim of the present invention does not need to reach all the disclosed objects, advantages, and uniqueness of the invention. Besides, the abstract and the title are only used for assisting the search of the patent documentation and should not be construed as any limitation on the implementation range of the invention.

## Claims

1. A method for fabricating a silicon wafer solar cell, comprising:
texturing a silicon wafer, forming a p-n junction, performing a wet chemical surface treatment, performing a passivation layer formation process, and performing electrodes formation processes;
wherein the wet chemical surface treatment comprises the following specific process flow:
performing a backside phosphosilicate glass (PSG) removal process by using a first etching solution, and the first etching solution to contact with the backside of the silicon wafer or contact with the backside and the edges of the silicon wafer, in order to remove phosphosilicate glass (PSG) on the backside of the silicon wafer or the backside and the edges of the silicon wafer, wherein the ratio of silicon dioxide etching rate to silicon etching rate of the first etching solution is more than or equal to 10/1; a front side of the silicon wafer is defined as the light incident surface after the silicon wafer is made into a solar cell; the backside of the silicon wafer is the surface opposite to the front side, and the edges of the silicon wafer are the surfaces connected in between the front side and the backside;
performing an edge isolation process by using a second etching solution, and having the second etching solution contact with the backside and the front side of the silicon wafer or contact with the backside, the edges, and the periphery of the front side of the silicon wafer because of liquid surface tension, to etch the backside and the edges of the silicon wafer so as to have the front side and the backside be electrically decoupled at the edges; wherein the ratio of silicon etching rate to phosphosilicate glass oxide etching rate of the second etching solution is more than or equal to 5/1;
performing a double-side phosphosilicate glass and oxide removal process by using a third etching solution to contact with the front side and the backside of the silicon wafer to remove phosphosilicate glass and other oxides on the surfaces of the silicon wafer.

2. The method according to claim 1, wherein the wet chemical surface treatment further comprises:
performing a front-side shallow junction formation process after the double-side phosphosilicate glass and oxide removal process by using a fourth etching solution to contact with the front side and the backside of the silicon wafer to etch silicon on the surfaces of the silicon wafer so as to reduce the distance between a p-n junction of the front side and the surface of the front side of the silicon wafer and hence to form a front-side shallow junction.

3. The method according to claim 1, wherein the edge isolation process uses the second etching solution to etch silicon by a thickness of about 0.5µm∼15µm (micro-meter) so as to form a smoother surface structure and thereby achieves a backside polish effect and increases the reflectivity of the backside of the silicon wafer.

4. The method according to claim 2, wherein, in the front-side shallow junction formation process, the etched thickness of silicon on the front side of the silicon wafer is between 20 nm (nano-meter) and 200 nm.

5. The method according to claim 1, wherein the first etching solution is an acidic solution comprising fluoride ions, the second etching solution is an alkaline solution, and the third etching solution is an acidic solution comprising fluoride ions.

6. The method according to claim 2, wherein the first etching solution is an acidic solution comprising fluoride ions, the second etching solution is an alkaline solution, the third etching solution is an acidic solution comprising fluoride ions, and the fourth etching solution is an alkaline solution.

7. The method according to claim 5, wherein
the first etching solution comprises one compound selected from the group consisting of the following: hydrofluoric acid (HF), ammonium fluoride (NH₄F), ammonium hydrogen fluoride (NH₄HF₂), and trifluoroacetic acid (CF₃COOH);
the second etching solution comprises one compound selected from the group consisting of the following: sodium hydroxide (NaOH), potassium hydroxide (KOH), sodium carbonate (Na₂CO₃), and potassium carbonate (K₂CO₃); and
the third etching solution comprises one compound selected from the group consisting of the following: hydrofluoric acid (HF), ammonium fluoride (NH₄F), ammonium hydrogen fluoride (NH₄HF₂), and trifluoroacetic acid (CF₃COOH).

8. The method according to claim 6, wherein
the first etching solution comprises one compound selected from the group consisting of the following: hydrofluoric acid (HF), ammonium fluoride (NH₄F), ammonium hydrogen fluoride (NH₄HF₂), and trifluoroacetic acid (CF₃COOH);
the second etching solution comprises one compound selected from the group consisting of the following: sodium hydroxide (NaOH), potassium hydroxide (KOH), sodium carbonate (Na₂CO₃), and potassium carbonate (K₂CO₃);
the third etching solution comprises one compound selected from the group consisting of the following: hydrofluoric acid (HF), ammonium fluoride (NH₄F), ammonium hydrogen fluoride (NH₄HF₂), and trifluoroacetic acid (CF₃COOH); and
the fourth etching solution comprises one compound selected from the group consisting of the following: tetramethyl ammonium hydroxide (TMAH), ethylene-diamine pyrocatechol water (EDP), hydrazine, sodium hydroxide, potassium hydroxide, sodium carbonate, and potassium carbonate.

9. The method according to claim 1, wherein the wet chemical surface treatment process flow uses a roller conveyor means to transport silicon wafers horizontally to perform each process of the wet chemical surface treatment sequentially; and between steps of the wet chemical surface treatment, (i.e. between the backside phosphosilicate glass (PSG) removal process and the edge isolation process and between the edge isolation process and the double-side phosphosilicate glass and oxide removal process) there are furthermore water rinse processes performed for rinsing the wafers.

10. The method according to claim 2, wherein the wet chemical surface treatment process flow uses a roller conveyor means to transport silicon wafers horizontally to perform each process of the wet chemical surface treatment sequentially; and between steps of the wet chemical surface treatment, (i.e. between the backside phosphosilicate glass (PSG) removal process and the edge isolation process, between the edge isolation process and the double-side phosphosilicate glass and oxide removal process, and between the double-side phosphosilicate glass and oxide removal process and the front-side shallow junction formation process) there are furthermore water rinse processes performed for rinsing the wafers.

11. A wet chemical surface treatment process flow suitable for fabricating a silicon wafer solar cell, and the process flow comprising:
performing a backside phosphosilicate glass (PSG) removal process by using a first etching solution and the first etching solution contacts with the backside of the silicon wafer or contact with the backside and the edges of the silicon wafer, to remove phosphosilicate glass (PSG) on the backside of the silicon wafer or the backside and the edges of the silicon wafer wherein the ratio of silicon dioxide etching rate to silicon etching rate of the first etching solution is more than or equal to 10/1; a front side of the silicon wafer is defined as the light incident surface after the silicon wafer is made into a solar cell; the backside of the silicon wafer is the surface opposite to the front side, and the edges of the silicon wafer are the surfaces connected in between the front side and the backside;
performing an edge isolation process by using a second etching solution and the second etching solution contacts with the backside and the front side of the silicon wafer or contacts with the backside, the edges, and the periphery of the front side of the silicon wafer because of liquid surface tension, to etch the backside and edges of the silicon wafer so as to have the front side and the backside be electrically decoupled at the edges; wherein the ratio of silicon etching rate to phosphosilicate glass oxide etching rate of the second etching solution is more than or equal to 5/1; and
performing a double-side phosphosilicate glass and oxide removal process by using a third etching solution to contact with the front side and backside of the silicon wafer in order to remove phosphosilicate glass and other oxides on the surfaces of the silicon wafer.

12. The process flow according to claim 11, further comprising:
performing a front-side shallow junction formation process after the double-side phosphosilicate glass and oxide removal process by using a fourth etching solution to contact with the front side and the backside of the silicon wafer in order to etch silicon on the surfaces of the silicon wafer so as to reduce the distance between a p-n junction of the front side and the surface of the front side of the silicon wafer and hence forming a front-side shallow junction.

13. The process flow according to claim 11, wherein the edge isolation process uses the second etching solution to etch silicon by a thickness of about 0.5µm∼15µm (micro-meter) so as to form a smoother surface structure and thereby achieves a backside polish effect and increases the reflectivity of the backside of the silicon wafer.

14. The process flow according to claim 11, wherein the wet chemical surface treatment process flow uses a roller conveyor means to transport silicon wafers horizontally to perform each process of the wet chemical surface treatment sequentially; and between steps of the wet chemical surface treatment, (i.e. between the backside phosphosilicate glass (PSG) removal process and the edge isolation process and between the edge isolation process and the double-side phosphosilicate glass and oxide removal process) there are furthermore water rinse processes performed for rinsing the wafers.

15. The process flow according to claim 12, wherein the wet chemical surface treatment process flow uses a roller conveyor means to transport silicon wafers horizontally to perform each process of the wet chemical surface treatment sequentially; and between steps of the wet chemical surface treatment, (i.e. between the backside phosphosilicate glass (PSG) removal process and the edge isolation process, between the edge isolation process and the double-side phosphosilicate glass and oxide removal process, and between the double-side phosphosilicate glass and oxide removal process and the front-side shallow junction formation process) there are furthermore water rinse processes performed for rinsing the wafers.

16. A method for fabricating a silicon wafer solar cell, comprising:
texturing a silicon wafer, forming a p-n junction, performing a wet chemical surface treatment, performing a passivation layer formation process, and performing electrodes formation processes;
wherein the silicon wafer is transported horizontally by a roller conveyor means;
the wet chemical surface treatment processes sequentially is performed; and
the wet chemical surface treatment comprises the following specific process flow:
performing a phosphosilicate glass (PSG) removal process by using a first etching solution to remove all of phosphosilicate glass (PSG) on the surfaces of the silicon wafer or to remove phosphosilicate glass (PSG) on the backside of the silicon wafer wherein the silicon dioxide etching rate of the first etching solution is larger than the silicon etching rate of the first etching solution; a front side of the silicon wafer is defined as the light incident surface after the silicon wafer is made into a solar cell; the backside of the silicon wafer is the surface opposite to the front side, and the edges of the silicon wafer are the surfaces connected in between the front side and the backside;
performing an edge isolation process by using a second etching solution so as to have the front side and the backside be electrically decoupled at the edges;
performing a front-side shallow junction formation process by using a third etching solution to contact with the front side and the backside of the silicon wafer in order to etch silicon on the surfaces of the silicon wafer so as to reduce the distance between a p-n junction of the front side and the surface of the front side of the silicon wafer and hence forming a front-side shallow junction; and
performing water rinse processes between the process steps of the wet chemical surface treatment process flow for rinsing the silicon wafers.
